Europäisches Patentamt

(19) European Patent Office

Office européen des brevets

(11) Publication number: **0 409 844 B1**

## EUROPEAN PATENT SPECIFICATION

(45) Date of publication of patent specification: **08.06.94** (51) Int. Cl.5: **H03F 1/52, H04M 19/00**

(21) Application number: **89902759.3**

(22) Date of filing: **07.02.89**

(86) International application number:
**PCT/EP89/00137**

(87) International publication number:
**WO 90/09703 (23.08.90 90/20)**

(54) **AMPLIFIER ARRANGEMENT AND COMMUNICATION LINE CIRCUIT USING SAME.**

(43) Date of publication of application:
**30.01.91 Bulletin 91/05**

(45) Publication of the grant of the patent:
**08.06.94 Bulletin 94/23**

(84) Designated Contracting States:
**BE CH DE FR IT LI**

(56) References cited:
**EP-A- 0 106 378**
**GB-A- 2 149 618**
**US-A- 3 990 020**

(73) Proprietor: **ALCATEL N.V.**
**Strawinskylaan 341,**
**(World Trade Center)**
**NL-1077 XX Amsterdam(NL)**
(84) Designated Contracting States:
**CH IT LI**

(73) Proprietor: **BELL TELEPHONE MANUFACTUR-**
**ING COMPANY NAAMLOZE VENNOOTSCHAP**
**Francis Wellesplein 1**
**B-2018 Antwerpen(BE)**

(84) Designated Contracting States:
**BE DE FR**

(72) Inventor: **WILLOCX, Eddie, Louis, Marie**
**Breendonkstraat 194**
**B-2660 Willebroek(BE)**

(74) Representative: **Vermeersch, Robert et al**
**BELL TELEPHONE MANUFACTURING COM-**
**PANY**
**Naamloze Vennootschap**
**Patent Department**
**Francis Wellesplein 1**
**B-2018 Antwerpen (BE)**

## Description

The present invention relates to an amplifier arrangement including at least two amplifiers each able to convey DC current through an element which is common to both said amplifiers, each of which has an associated individual overcurrent detection circuit coupled to a current limiting circuit.

Such an amplifier arrangement is already known from the British patent GB-A-2 149 618 where, as mentioned, use is made of the amplifiers disclosed in the Belgian patent No 894 437 corresponding to US-A-456879 and EP-A-0 106 378. This known amplifier arrangement forms part of a communication line circuit wherein the conductors of a communication line are connected to the outputs of respective ones of the amplifiers. Each of these amplifiers is able to source current to the associated line conductor, as well as to sink current from the associated line conductor to a negative supply voltage and through a transistor which is common to both the amplifiers and constitutes the above mentioned common element. This transistor forms part of a DC impedance synthesis circuit and to this end it has a suitable frequency characteristic. Normally one amplifier sources current, whereas the other sinks current to the negative supply voltage and through the common transistor, and each of these currents and especially the sink current is limited to a predetermined value. However, it may happen that due to a voltage erroneously connected to both line conductors both amplifiers sink currents to the negative supply voltage and through the common transistor. Thus one must take care that even in such a case the transistor will not be damaged. A possible solution to this problem would be to use a power transistor able to withstand the higher current due to such a faulty condition. However, such a power transistor having the required frequency characteristic is presently not available on the market. On the other hand, even if it were available it would not be used because a power amplifier necessitates associated cooling means which, together with the transistor, occupy too much space in a chip.

An object of the present invention is to provide an amplifier arrangement of the above type, but which substantially reduces the magnitude of the current through the common element when both amplifiers are simultaneously brought in a condition wherein they tend to convey excessive currents.

According to the invention this object is achieved due to the fact that the amplifier arrangement further includes a common overcurrent detection circuit whose inputs are coupled to outputs of respective ones of said individual overcurrent detection circuits and having outputs on which respective first and second control signals are generated, the condition of each of said control signals indicating that the current detected by the associated individual overcurrent detection circuit exceeds a predetermined threshold or not, and a common gating circuit controlled by said first and second control signals and generating an output signal controlling the current limiting circuits of said amplifiers.

Thus the output signal of the gating circuit is function at least of the condition of both the control signals provided by the common current detection circuit and may be used, when both these control signals indicate the flow of excessive amplifier currents, to control the current limiting circuits of the amplifiers.

Another characteristic feature of the present amplifier arrangement is that that the current limiting circuit of each of said amplifiers is in a first/second condition wherein it limits the current, conveyed by this amplifier into said element, to a first/second value depending on the first/second condition of said gating circuit output signal.

In this way the gating circuit may bring each of the amplifiers in a power up/down condition wherein it limits the current flowing therein to a higher/lower value.

The above mentioned and other objects and features of the invention will become more apparent and the invention itself will be best understood by referring to the following description of an embodiment taken in conjunction with the accompanying drawings wherein :

Fig. 1 is a schematic diagram of part of an amplifier arrangement forming part of a communication line circuit, both according to the invention;

Fig. 2 represents part of amplifier LOA1 as well as the circuits OCD1, OCD3, GC1 and CLC1 of Fig. 1 in more detail;

Fig. 3 shows a variant of circuit OCD1 of Fig. 2.

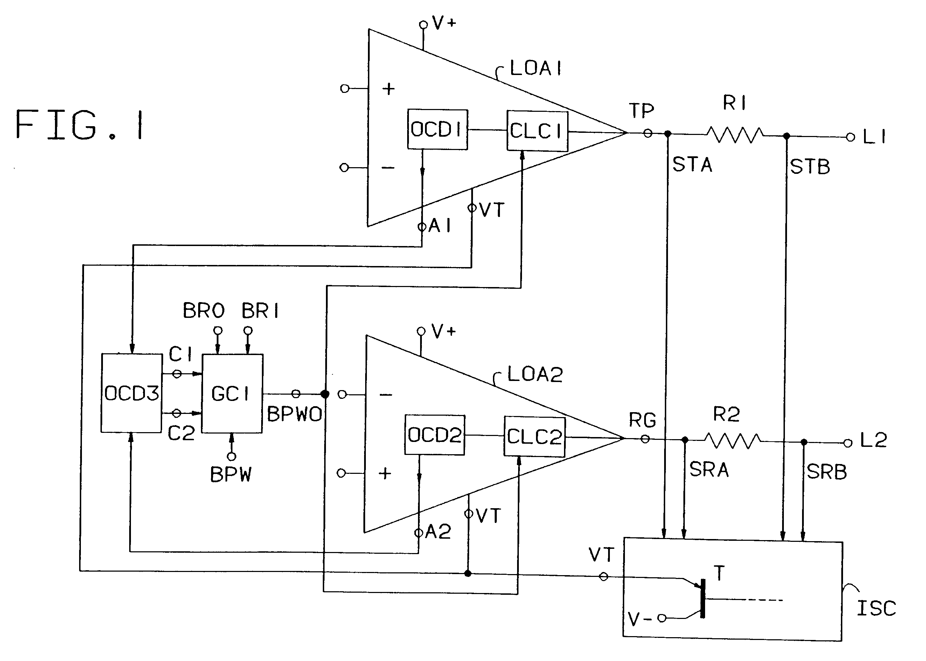

The amplifier arrangement shown in Fig. 1 forms part of a communication line circuit which operates with the following supply voltages :

V + which is at ground potential;

V- which is at a negative battery potential;

VAUX which is an auxiliary potential above V-, e.g. 75% of the total battery voltage.

This line circuit is for instance of the type disclosed in the above mentioned patents as well as in the published EP-A-0 201 635. It includes two identical operational line amplifiers LOA1 and LOA2 whose non-inverting and inverting inputs are connected to not shown circuitry and the respective outputs TP and RG of

2

which are coupled to conductors L1 and L2 of a communication line through respective feed resistances R1 and R2. Each of the line amplifiers is fed between V+ and a regulated voltage VT provided at the like named output VT of a DC impedance synthesizing circuit ISC whose inputs are connected to the terminals STA, STB and SRA and SRB of the feed resistances R1 and R2 respectively. The output VT of ISC is constituted by the emitter of a PNP output transistor T whose collector is connected to V-. The transistor T is not a power transistor and has a suitable frequency characteristic to fulfill its function in the circuit ISC.

Under normal circumstances one of the line amplifiers LOA1/2, e.g. LOA1, sources DC current on its associated line conductor L1 from V+, whereas the other LOA2 sinks DC current to VT from its associated line conductor L2. The latter current further flows to V-through transistor T. The regulated voltage VT then has a value between V+ and V- and the voltage on the line conductors is somewhat, e.g. 3.5 Volts, below V+ and above VT respectively. Under these circumstances the transistor T operates correctly even when the tolerances for the voltage V- are such that it can reach a relatively high negative value.

However, when due to a fault both line conductors L1 and L2 are for instance connected to V+, both the amplifiers LOA1/2 will then sink DC current. This means that a DC current will then flow from V+ on the line conductor to the common terminal VT in each of the amplifiers and that both these DC currents will flow together from VT to V- through transistor T. As a consequence the transistor T would be damaged if no precautions were taken, especially when V- has a relatively high negative value.

While maintaining the transistor T, a lower current becomes possible when the line circuit shown further includes individual overcurrent detection circuits OCD1 and OCD2 forming part of the respective amplifiers LOA1 and LOA2 and having outputs A1 and A2 which are connected to the common overcurrent detection circuit OCD3 located outside LOA1/2. The circuit OCD3 has outputs C1 and C2 which are connected to the like named inputs of a gating circuit GC1, together with other inputs BPW, BR0 and BR1 to be considered later. The gating circuit GC1 has an output BPWO which controls current limiting circuits CLC1 and CLC2 in the respective amplifiers LOA1 and LOA2.

The purpose of the overcurrent detection circuitry OCD1/2/3 is to detect when an excessive sink current flows in each of the amplifiers LOA1 and LOA2 and that of the gating circuit GC1 is to detect when this happens simultaneously and to then bring the current limiting circuits CLC1 and CLC2 in these amplifiers in a so-called power down condition wherein they limit the current to a lower value.

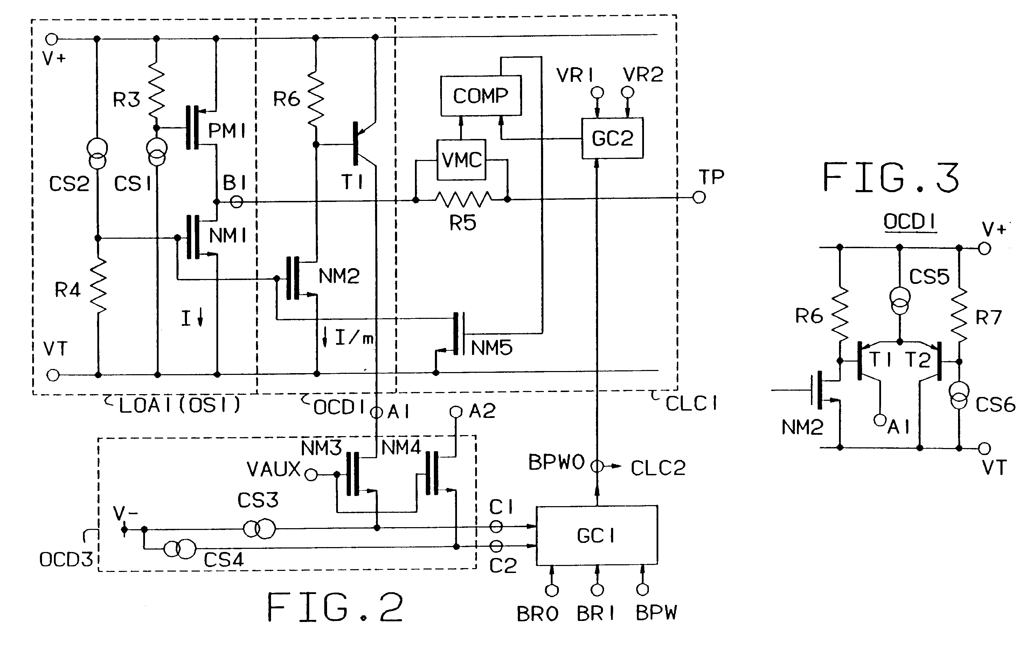

Reference is now made to Fig. 2 which shows the output stage OS1 of the line amplifier LOA1 together with the associated and schematically represented DC bias circuit as well as the above mentioned circuits OCD1, OCD3 and CLC1 in more detail.

The line amplifier LOA1 is for instance of the type disclosed in the above mentioned US-A-4564879. Its output stage OS1 is constituted by a PMOS transistor PM1 and an NMOS transistor NM1 whose main current paths are connected in series between V+ and VT and whose gates are connected to respective DC bias circuits which are each schematically represented by the series connection of a constant current source CS1/2 and a resistance R3/4. More in detail, the gate of PM1 is connected to the junction point of R3 and CS1, whilst the gate of NM1 is connected to the junction point of CS2 and R4. The junction point B1 of PM1 and NM1 is coupled to the output terminal TP of LOA1 through a measurement resistance R5 forming part of the current limiting circuit CLC1.

The individual overcurrent detection circuit OCD1 forming part of the amplifier LOA1 includes an NMOS transistor NM2 connected in current mirror configuration with transistor NM1 as well as a resistor R6 which is connected in series with the drain-to-source path of NM2 between V+ and VT, i.e. in parallel with PM1, NM1. The junction point of R6 and NM2 is connected to the base of PNP transistor T1 whose emitter-to-collector path is connected, between V+ and V-, in series with the drain-to-source path of NMOS transistor NM3 and constant current source CS3 which both form part of the common overcurrent detection circuit OCD3, the gate of NM3 being connected to VAUX. The collector of T1 constitutes the above mentioned output A1 of OCD1 and the junction point C1 of NM3 and CS3 is connected to the like named input C1 of the gating circuit GC1. The elements R6, T1, NM3, CS3 together constitute a current-to-voltage converter.

The line amplifier LOA2 is identical to LOA1 and the individual overcurrent detection circuit OCD2 associated to its output stage (not shown) and having output A2 is connected to the common overcurrent detection circuit OCD3. More particularly, the output A2 is connected to the drain electrode of an NMOS transistor NM4 whose drain-to-source path is connected to V- in series with constant current source CS4. The junction point C2 of NM4 and CS4 which are identical to NM3 and CS3 is connected to the like named input C2 of the gating circuit GC1.

To the gating circuit GC1 is further coupled a so-called digital signal processor DSP (not shown) described in the above mentioned EP-A-0 201 635 and GB-A-2 149 618. The DSP applies the following three control signals to the above mentioned inputs BR0, BR1 and BPW of GC1 :

BR0 and BR1 :    by these binary control signals the DSP informs the line circuit of the fact that the voltages on the outputs TP/RG of LOA1/2 have higher (H) or lower (L) values, according to the following truth table :

| BR0 | BR1 | TP | RG |
|-----|-----|----|----|
| 0 | 0 | H | L |
| 1 | 0 | L | H |
| 0 | 1 | H | H |
| 1 | 1 | L | L |

While their overall function is the same as in the last mentioned patent their binary conditions now indicate other conditions of TP/RG.

The condition for which BR0 = BR1 = 1 is the so called ground (i.e. V+) detection condition, wherein both the amplifiers LOA1/2 sink current in a controlled way.

BPW :     by this binary control signal the DSP attempts to bring the line circuit in a power up (BPW = 1) or down (BPW = 0) condition, i.e. in a condition wherein the current limiting circuit CLC1/2 of each amplifier LOA1/2 limits the current flowing therein to a higher/lower value, as will be explained later.

In response to the received control signals applied thereat the gating circuit GC1 provides an individual power up/down signal BPWO which may be represented by the following Boolean function :

$$BPWO = (\overline{C1} + \overline{C2} + BR0.BR1).BPW \qquad (1)$$

and which effectively controls both the current limiting circuits CLC1/2. From the relation (1) it follows that when BPW is on 0 the same is true for BPWO, but that when BPW is on 1 the signal BPWO may be on 0. This happens more particularly when simultaneously C1 = C2 = 1 and BR0.BR1 = 0, the first condition corresponding to an overcurrent detected in both the amplifiers LOA1/2 and the second to no ground detection operation being performed therein.

The output BPWO of GC1 is connected to both the current limiting circuits CLC1 and CLC2 included in LOA1 and LOA2 respectively and of which only CLC1 is shown in Fig. 2. The output BPWO is more particularly connected to a control input of a gating circuit GC2 which has two further inputs to which respective reference voltages VR1 and VR2 are applied, VR1 being higher than VR2. Depending on the 1/0 condition of the signal BPWO on the like named output BPWO either the voltage VR1 or VR2 appears at the output of GC2. The latter output is connected to one input of a voltage comparator COMP who the other input is connected to the output of a voltage measurement circuit VMC branched across the resistance R5 and able to measure the voltage drop of a sink current flowing from TP to NM1. The output of the comparator COMP is coupled to the gate of NMOS transistor NM5 whose drain is connected to the commoned gates of NM1, NM2 and whose source is biassed by VT.

In the normal condition of operation of the line circuit the output transistors PM1 and NM1 of each of the line amplifiers LOA1/2 are suitably biassed by the DC bias circuits schematically represented by the elements R3, CS1 and CS2, R4 respectively. Either the transistor PM1 then sources current to the output TP/RG from V+ and via the resistance R5, or transistor NM1 sinks current from this output to VT, again via the resistance R5. In the latter case the current, say I, flowing through NM1 is mirrored in transistor NM2 with a ratio equal to I/m when the source surface of NM1 is m times that of NM2. A current I/m therefore flows from V+ to VT via resistance R6 and NM2, thus decreasing the power consumption in this resistance. Normally the voltage thus developed across this resistance R6 is smaller than the threshold voltage VBE of the PNP transistor T1 so that the latter remains blocked.

In case the line circuit is in the effective power up condition for which BPWO is on 1, the gating circuit GC2 connects the higher reference voltage VR1 to the comparator COMP. In this case a sink current flowing from output TP or RG to VT via resistance R5 and transistor NM1 is only reduced if it exceeds a predetermined higher value. More particularly, when it produces across R5 a voltage drop exceeding VR1 the output of the comparator COMP becomes activated (i.e. logical 1) due to which transistor NM5 becomes conductive. As a consequence current is then deviated from the gates of transistors NM1 and NM2 thus reducing the sink current flowing through NM1.

On the contrary, when the line circuit is in the power down condition for which BPWO is on 0 the gating circuit GC2 connects the lower reference voltage VR2 to the comparator COMP, so that the output thereof is activated only when the voltage drop produced by the sink current flowing through resistance R5 and NM1 to VT and measured by the circuit VMC exceeds the value VR2. This means that when BPWO is on 0

4

EP 0 409 844 B1

a lower sink current is allowed to flow through NM1 than in case BPWO is on 1.

In case the line circuit is in the effective power up condition, for which BPWO is on 1, and when no ground detection is taking place, i.e. when simultaneously BPW = 1 and BR0.BR1 = 0, the erroneous connection of voltage, e.g. V+, to both the line conductors L1 and L2 and giving rise to excessive sink currents in both the amplifiers LOA1/2 has for effect that the signal BPWO is brought in the 0 condition and that accordingly the line circuit is put in the effective power down condition. Indeed, when the voltage produced across the resistance R6 of amplifier LOA1 by the current I/m exceeds the VBE voltage of transistor T1 the latter becomes conductive. As a consequence a current is then able to flow from V+ to V- via transistors T1, NM3 and the constant current source CS3 in series. The same is true for the amplifier LOA2 where a current then flows from V+ to V- through transistors T1 (of LOA2, not shown) and NM4 and constant current source CS4 in series, As a result the source voltages of the transistors NM3 and NM4 each change from 0 to VAUX-VGS, wherein VGS is the gate-to-source of these transistors. This means that the outputs C1 and C2 of transistors NM3 and NM4 both become activated (logical 1). From the above relation (1) it follows that the output BPWO of the gating circuit GC1 then becomes de-activated (logical 0), thus bringing the current limiting circuits CLC1/2 both in the power down condition.

As described above, transistor T1 becomes conductive when its VBE voltage is exceeded by the voltage drop produced across resistance R6 by the current I/m. While in an integrated circuit the factor m may be made very accurate this is not so for the resistance R6 and for the voltage VBE which are dependent on temperature. This gives rise to small errors although R6 may be given a negative temperature coefficient to substantially match that of the base-to- emitter junction of T1.

In case such small errors should be avoided use may be made of the circuit of Fig. 3. Therein the PNP transistor T1, together with another PNP transistor T2, forms part of a comparator wherein a constant current source CS5 is connected between V+ and the emitters of transistors T1 and T2 whose collectors are connected to the drain electrode A1 of transistor NM3 and to VT respectively. The base of T1 is again connected to the junction point of R6 and NM2, whereas the base of T2 is connected to the junction point of a resistance R7 and a constant current source CS6 which are connected in series between V+ and VT. As a consequence the threshold voltage produced across resistance R7 and the voltage to be detected across resistance R6 are dependent on respective resistances R6 and R7 and these may be easily matched. Thus the accuracy of the comparison is only dependent on the accuracy of the factor m.

To reduce the power consumption in resistance R7 the latter can be given a value which is n times higher than that of R6, by using a current source CS6 which produces a current n times smaller than that for which T1 becomes conductive.

While the principles of the invention have been described above in connection with specific apparatus, it is to be clearly understood that this description is made only by way of example and not as a limitation on the scope of the invention.

**Claims**

1.  Amplifier arrangement including at least two amplifiers (LOA1/2) each able to convey DC current through an element (T) which is common to both said amplifiers (LOA1/2), each of which has an associated individual overcurrent detection circuit (OCD1/2) coupled to a current limiting circuit (CLC1/2), characterized in that it further includes a common overcurrent detection circuit (OCD3) whose inputs (A1/2) are coupled to outputs (A1/2) of respective ones of said individual overcurrent detection circuits (OCD1/2) and having outputs (C1/2) on which respective first (C1) and second (C2) control signal are generated, the condition of each of said control signals indicating that the current detected by the associated individual overcurrent detection circuit (OCD1/2) exceeds a predetermined threshold or not, and a common gating circuit (GC1) controlled by said first (C1) and second (C2) control signals and generating an output signal (BPWO) controlling the current limiting circuits (CLC1/2) of said amplifiers (LOA1/2).

2.  Amplifier arrangement according to claim 1, characterized in that the current limiting circuit (CLC1/2) of each of said amplifiers (LOA1/2) is in a first/second condition wherein it limits the current, conveyed by this amplifier into said element (T), to a first/second value depending on the first/second condition of said gating circuit output signal (BPWO).

3.  Amplifier arrangement according to claim 2, characterized in that said gating circuit (GC1) has a third input (BPW) controlled by a third control signal (BPW) whose first/second condition considered separately brings said gating circuit output signal (BPWO) in its said first/second condition respectively.

5

**4.** Amplifier arrangement according to claim 2, characterized in that said gating circuit (GC1) has a fourth input (BR0) controlled by a fourth control signal (BR0) whose first/second condition considered separately brings said gating circuit output signal (BPWO) in its said first/second condition respectively, as well as a fifth input (BR1) controlled by a fourth control signal (BR1) whose first/second condition considered separately brings said gating circuit output signal (BPWO) in its said first/second condition respectively.

**5.** Amplifier circuit according to claims 3 and 4, characterized in that said gating circuit output signal (BPWO) may be represented by the Boolean function :

$$BPWO = (\overline{C1} + \overline{C2} + BR0.BR1). \; BPW$$

wherein BPWO is said gating circuit output signal and C1, C2, BPW, BR0 and BR1 are said first, second, third, fourth and fifth control signals respectively.

**6.** Amplifier arrangement according to claim 1, characterized in that each of said amplifiers (LOA1/2) includes a first transistor (NM1) which conveys said current and which is coupled in series with said common element, that is constituted by a second transistor (T), between the amplifier output (TP) and a supply voltage (V-), said first transistor (NM1) being coupled in current mirror configuration with a third transistor (NM2) whose main current path forms part of said overcurrent detection circuit (OCD1/2).

**7.** Amplifier arrangement according to claim 6, characterized in that each of said individual overcurrent detection circuits (OCD1/2) and a respective part (NM3, CS3; NM4, CS4) of said common overcurrent detection circuit (OCD3) together constitute a current-to-voltage converter which includes in said individual circuit (OCD1) an impedance (R6) connected in the main current path of said third transistor (NM2), means to compare the voltage produced across said impedance (R6) with a predetermined voltage threshold and to operate a fourth transistor (T1) having an output (A1) which is an output of the individual circuit (OCD1) when the threshold is exceeded, said fourth transistor (T1) being coupled in said common circuit (OCD3) in series with the main current path of a fifth transistor (NM3) and a constant current source (CS3), said fifth transistor (NM3) having a constant gate voltage (VAUX) and its junction point with said constant current source constituting an output (C1) of said common circuit (OCD3).

**8.** Amplifier arrangement according to claim 7, characterized in that said predetermined voltage threshold is the forward base-to-emitter voltage (VBE) of said second transistor (T1) whose emitter-to-base junction is shunted by said impedance (R6).

**9.** Amplifier arrangement according to claim 7, characterized in that said voltage comparison means include a sixth transistor (T2) whose base is connected to the junction point of a second impedance (R7) and a second constant current source (CS6) which are connected in series between two voltages (V +, VT) and in parallel with the series connection of said first impedance (R6) and said second transistor (NM2), the main current paths of said fourth (T1) and sixth (T2) transistors being fed from a third constant current source (CS5).

**10.** Communication line circuit including an amplifier arrangement according to any of the claims 1 to 9, characterized in that the outputs of said amplifiers (LOA1/2) are connected to respective conductors (L1/2) of a communication line.

**11.** Communication line circuit according to claims 3, 4 and 10, characterized in that said third (BPW), fourth (BR0) and fifth (BR1) control signals are provided by a controlling processor (DSP).

**Patentansprüche**

**1.** Verstärkeranordnung, welche wenigstens zwei Verstärker (LOA1/2) enthält, von denen jeder Gleichstrom durch ein Element (T) leiten kann, welches zu beiden Verstärkern (LOA1/2) gehört, von denen jeder eine individuelle Überstromprüfschaltung (OCD1(2) enthält, welche mit einer Strombegrenzungsschaltung (CLC1/2) gekoppelt ist,
dadurch gekennzeichnet, daß sie außerdem eine gemeinsame Überstromprüfschaltung (OCD3) enthält, deren Eingänge (A1/2) mit den Ausgängen (A1/2) der entsprechenden individuellen Überstromprüfschaltungen (OCD1/2) gekoppelt sind und welche Ausgänge (C1/2) besitzen, an denen entsprechende erste (C1) und zweite (C2) Steuersignale vorhanden sind, wobei der Wert eines jeden Steuersignals anzeigt, ob der von der zugeordneten individuellen Überstromprüfschaltung (OCD1/2) geprüfte Strom einen bestimmten Schwellenwert übersteigt oder nicht, und eine gemeinsame Torschaltung (GC1), welche von den ersten (C1) und zweiten (C2) Steuersignalen gesteuert ist und ein Ausgangssignal (BPWO) erzeugt, welches die Strombegrenzungsschaltungen (CLC1/2) der Verstärker (LOA1/2) steuert.

2. Verstärkeranordnung nach Anspruch 1,
dadurch gekennzeichnet, daß die Strombegrenzungsschaltung (CLC1/2) eines jeden Verstärkers (LOA1/2) sich in einem ersten/zweiten Zustand befindet, in welchem sie den Strom, welcher von dem Verstärker in das Element (T) geleitet wird, auf einen ersten/zweiten Wert begrenzt, welcher von dem ersten/zweiten Zustand des Ausgangssignals (BPWO) der Torschaltung abhängt.

3. Verstärkeranordnung nach Anspruch 2,
dadurch gekennzeichnet, daß die Torschaltung (GC1) einen dritten Eingang (BPW) besitzt, welcher von einem dritten Steuersignal (BPW) gesteuert wird, dessen erster/zweiter Zustand das Ausgangssignal (BPWO) der Torschaltung jeweils in den ersten/zweiten Zustand bringt.

4. Verstärkeranordnung nach Anspruch 2,
dadurch gekennzeichnet, daß die Torschaltung (GC1) einen vierten Eingang (BR0) besitzt, welcher von einem vierten Steuersignal (BR0) gesteuert wird, dessen erster/zweiter Zustand das Ausgangssignal (BPWO) der Torschaltung jeweils in den ersten/zweiten Zustand bringt und daß sie einen fünften Eingang (BR1) besitzt, welcher von einem vierten Steuersignal (BR1) gesteuert wird, dessen erster/zweiter Zustand das Ausgangssignal (BPWO) der Torschaltung jeweils in den ersten/zweiten Zustand bringt.

5. Verstärkerschaltung nach den Ansprüchen 3 und 4,
dadurch gekennzeichnet, daß das Ausgangssignal (BPWO) der Torschaltung durch folgende Bool'sche Gleichung dargestellt werden kann:
$BPWO = (\overline{C1} + \overline{C2} + BR0 \bullet BR1) \bullet BPW$, in welcher BPWO das Ausgangssignal der Torschaltung ist und C1, C2, BPW, BR0 und BR1 jeweils das erste, zweite, dritte, vierte und fünfte Steuersignal sind.

6. Verstärkeranordnung nach Anspruch 1,
dadurch gekennzeichnet, daß jeder der Verstärker (LOA1/2) einen ersten, den Strom leitenden Transistor (NM1) enthält, der in Serie mit dem gemeinsamen Element geschaltet ist, welches aus einem zweiten Transistor (T) zwischen dem Verstärkerausgang (TP) und einer Versorgungsspannung (V-) besteht, wobei der erste Transistor (NM1) in Strom-Spiegel-Anordnung mit einem dritten Transistor (NM2) gekoppelt ist, dessen Haupt-Strompfad einen Teil der Überstromprüfschaltung (OCD1/2) bildet.

7. Verstärkeranordnung nach Anspruch 6,
dadurch gekennzeichnet, daß jede der individuellen Überstromprüfschaltungen (OCD1/2) und ein entsprechender Teil (NM3, CS3, NM4, CS4) der gemeinsamen Überstromprüfschaltung (OCD3) einen Strom-Spannungswandler bilden, bei dem in der individuellen Schaltung (OCD1) eine Impedanz (R6) im Hauptstrompfad des dritten Transistors (NM2) enthalten ist und Mittel zum Vergleichen der an der Impedanz (R6) vorhandenen Spannung mit einem bestimmten Spannungs-Schwellenwert und zum Betreiben eines vierten Transistors (T1) mit dem Ausgang (A1), welcher der Ausgang der individuellen Schaltung (OCD1) ist, wenn der Schwellenwert überschritten ist; der vierte Transistor (T1) liegt in der gemeinsamen Schaltung (OCD3) in Reihe mit dem Haupt-Strompfad des fünften Transistors (NM3) und einer Konstant-Stromquelle (CS3), wobei der fünfte Transistor (NM3) eine konstante Torspannung (VAUX) besitzt und der Verbindungspunkt mit der der Konstantstromquelle ein Ausgang (C1) der gemeinsamen Schaltung (OCD3) darstellt.

8. Verstärkeranordnung nach Anspruch 7,
dadurch gekennzeichnet, daß der bestimmte Spannungs-Schwellenwert die Vorwärts-Basis-Emitter-Spannung (VBE) des zweiten Transistors (T1) ist, dessen Emitter-Basis-Strecke die Impedanz (R6) parallel geschaltet ist.

**9.** Verstärkeranordnung nach Anspruch 7,
dadurch gekennzeichnet, daß die Mittel zum Spannungsvergleich einen sechsten Transistor (T2) aufweisen, dessen Basis mit dem Verbindungspunkt einer zweiten Impedanz (R7) und einer zweiten Konstantstrom-Quelle (CS6) verbunden ist, die in Reihe zu zwei Spannungen (V +, VT) und parallel zu einer Reihenschaltung aus der ersten Impedanz (R6) und dem zweiten Transistor (NM2) angeordnet sind, wobei der Haupt-Strompfad des vierten (T1) und des sechsten Transistors (T2) aus einer dritten Konstantstromquelle (CS5) gespeist wird.

**10.** Übertragungsleitungsschaltung mit einer Verstärkeranordnung nach einem der Ansprüche 1 bis 9,
dadurch gekennzeichnet, daß die Ausgänge dieser Verstärker (LOA1/2) mit den entsprechenden Leitern (L1/2) einer Übertragungsleitung verbunden sind.

**11.** Übertragungsleitungsschaltung nach den Ansprüchen 3, 4 und 10,
dadurch gekennzeichnet, daß das dritte (BPW), vierte (BR0) und fünfte Steuersignal von einem Steuerprozessor (DSP) geliefert werden.

**Revendications**

**1.** Agencement amplificateur comprenant au moins deux amplificateurs (LOA1/2) chacun capable d'acheminer un courant continu à travers un élément (T) qui est commun auxdits deux amplificateurs (LOA1/2), chacun desquels possède un circuit individuel de détection de courant excessif (OCD1/2) qui lui est associé, couplé à un circuit limiteur de courant (CLC1/2), caractérisé en ce qu'il comporte en outre un circuit commun de détection de courant excessif (OCD3) dont les entrées (A1/2) sont respectivement couplées à des sorties (A1/2) desdits circuits individuels de détection de courant excessif (OCD1/2) et qui possède des sorties (C1/2) sur lesquelles sont respectivement engendrés un premier (C1) et un deuxième (C2) signal de commande, l'état de chacun de ces signaux de commande indiquant si le courant détecté par le circuit individuel de détection de courant excessif correspondant (OCD1/2) dépasse un seuil prédéterminé où non, et un circuit de porte commun (GC1) commandé par lesdits premier (C1) et deuxième (C2) signaux de commande et engendrant un signal de sortie (BPWO) commandant les circuits de limitation de courant (CLC1/2) desdits amplificateurs (LOA1/2).

**2.** Agencement amplificateur conforme à la revendication 1, caractérisé en ce que le circuit de limitation de courant (CLC1/2) de chacun desdits amplificateurs (LOA1/2) est dans un premier/second état, alors qu'il limite le courant acheminé par cet amplificateur dans ledit élément (T) à une première/seconde valeur qui dépend du premier/second état dudit signal de sortie de circuit de porte (BPWO).

**3.** Agencement amplificateur conforme à la revendication 2, caractérisé en ce que ledit circuit de porte (GC1)) a une troisième entrée (BPW) commandée par un troisième signal de commande (BPW) dont les premier/second états, considérés séparément, portent respectivement ledit signal de sortie de circuit de porte (BPWO) dans ses premier/second états.

**4.** Agencement amplificateur conforme à la revendication 2, caractérisé en ce que ledit circuit de porte (GC1) a une quatrième entrée (BR0) commandée par un quatrième signal de commande (BR0) dont des premier/second états considérés séparément portent respectivement ledit signal de sortie de circuit de porte (BPWO) dans son premier/second état, de même qu'une cinquième entrée (BR1) commandée par un cinquième signal de commande (BR1) dont les premier/second états, considérés séparément, portent ledit signal de sortie de circuit de porte (BPWO) dans ses premier/second états.

**5.** Agencement amplificateur conforme aux revendications 3 et 4, caractérisé en ce que ledit signal de sortie de circuit de porte (BPWO) peut être représenté par la fonction booléenne:

$$BPWO = (\overline{C1} + \overline{C2} + BR0.BR1).BPW$$

dans laquelle BPWO est ledit signal de sortie de circuit de porte, et C1, C2, BPW, BR0 et BR1 sont respectivement desdits premier, deuxième, troisième, quatrième et cinquième signaux de commande.

**6.** Agencement amplificateur conforme à la revendication 1, caractérisé en ce que chacun desdits amplificateurs (LOA1/2) inclut un premier transistor (NM1) qui achemine ledit courant et qui est couplé en série avec ledit élément commun, lequel est constitué par un deuxième transistor (T) entre la sortie de l'amplificateur (TP) et une tension d'alimentation (-V), ledit premier transistor (NM1) étant couplé en configuration de miroir de courant avec un, troisième transistor (NM2) dont le trajet de courant principal fait partie dudit circuit de détection de courant excessif (OCD1/2).

7. Agencement amplificateur conforme à la revendication 6, caractérisé en ce que chacun desdits circuits individuels de détection de courant excessif (OCD1/2) et une partie correspondante (NM3, CS3, NM4, CS4) dudit circuit commun de détection de courant excessif (OCD3) constituent ensemble un convertisseur courant-tension qui comporte, dans ledit circuit individuel (OCD1) une impédance (R6) connecté dans le trajet de courant principal dudit troisième transistor (NM2), des moyens pour comparer la tension produite aux bornes de ladite impédance (R6) à un seuil de tension prédéterminé et pour actionner un quatrième transistor (T1) ayant une sortie (A1) qui est une sortie du circuit individuel (OCD1), lorsque le seuil est dépassé, ledit quatrième transistor (T1) étant couplé dans ledit circuit commun (OCD3) en série avec le trajet de courant principal d'un cinquième transistor (NM3) et une source à courant constant (CS3), ledit cinquième transistor (NM3) ayant une tension de grille constante (VAUX) et son point de jonction avec ladite source à courant constant constituant une sortie (C1) dudit circuit commun (OCD3).

8. Agencement amplificateur conforme à la revendication 7, caractérisé en ce que ledit seuil de tension prédéterminé est la tension base-émetteur (VBE) dudit deuxième transistor (T1) dont la jonction émetteur-base est shuntée par ladite impédance (R6).

9. Agencement amplificateur conforme à la revendication 7, caractérisé en ce que lesdits moyens de comparaison de tension comprennent un sixième transistor (T2) dont la base est connectée au point de jonction d'une deuxième impédance (R7) et d'une deuxième source à courant constant (CS6) qui sont connectées en série entre deux tensions (V +, VT) et en parallèle avec la connexion en série de ladite première impédance (R6) et dudit deuxième transistor (NM2), les trajets de courant principaux desdits quatrième (T1) et sixième (T2) transistors étant alimentés par une troisième source à courant constant (CS5).

10. Circuit de ligne de communication incluant un agencement amplificateur conforme à l'une quelconque des revendications 1 à 9, caractérisé en ce que les sorties desdits amplificateurs (LOA1/2) sont respectivement connectés aux conducteurs (L1/2) d'une ligne de communication.

11. Circuit de ligne de communication conforme aux revendications 3, 4, 10, caractérisé en ce que lesdits troisième (BPW), quatrième (BR0) et cinquième (BR1) signaux de commande sont fournis par un processeur de commande (DSP).

FIG. 1

EP 0 409 844 B1

FIG.2

FIG.3

EP 0 409 844 B1